# EUROPEAN PATENT APPLICATION

(11) **EP 4 412 082 A1**
(43) Date of publication of application: **07.08.2024**
(21) Application number: 22876248.0
(22) Date of filing: 27.09.2022
(51) Int. Cl.: H03F 1/02, H02M 3/155, H03F 3/24

(54) **TRACKER MODULE**

(30) Priority: 29.09.2021 JP 2021159984
(71) Applicant: Murata Manufacturing Co., Ltd., Nagaokakyo-shi, Kyoto 617-8555 (JP)
(72) Inventor: ARAMATA, Tomohide, Nagaokakyo-shi, Kyoto 617-8555 (JP); KOGURE, Takeshi, Nagaokakyo-shi, Kyoto 617-8555 (JP); MATSUI, Toshiki, Nagaokakyo-shi, Kyoto 617-8555 (JP); FUKUDA, Yuuki, Nagaokakyo-shi, Kyoto 617-8555 (JP)
(74) Representative: Stöckeler, Ferdinand
(86) International application number: PCT/JP2022/035989
(87) International publication number: WO 2023/054382

(57) **Abstract**

A tracker module (100) includes an integrated circuit (80) disposed on or in a module substrate (90); and a plurality of external connection terminals including first to third external connection terminals. The integrated circuit (80) includes a switch included in a switched-capacitor circuit (20) configured to generate, based on an input voltage, a plurality of discrete voltages; a switch included in a supply modulator (30A) configured to selectively output, based on a first envelope signal, at least one of the plurality of discrete voltages to the first external connection terminal; and a switch included in a supply modulator (30B) configured to selectively output, based on a second envelope signal, at least one of the plurality of discrete voltages to the second external connection terminal. The third external connection terminal receives none of the plurality of discrete voltages from the supply modulators (30A and 30B). The third external connection terminal is disposed between the first and second external connection terminals in plan view of the module substrate (90).

## Description

### Technical Field

The present invention relates to a tracker module.

### Background Art

Patent Document 1 discloses a power supply modulation circuit capable of supplying a power amplifier (PA) with a power supply voltage that is dynamically adjusted over time in accordance with a radio frequency (RF) signal. Patent Document 2 discloses a power supply modulation circuit capable of supplying a plurality of PAs with such a power supply voltage.

### Citation List

### Patent Document

Patent Document 1: United States Patent No. 9,755,672

### Summary of Invention

### Technical Problem

When the power supply modulation circuit disclosed in Patent Document 2 is mounted in one module, a plurality of power supply voltages supplied to the plurality of PAs may interfere with each other.

Accordingly, the present invention provides a tracker module capable of supplying a plurality of power supply voltages to a plurality of PAs and reducing interference between the plurality of power supply voltages.

### Solution to Problem

A tracker module according to an aspect of the present invention includes a module substrate; at least one integrated circuit disposed on or in the module substrate; and a plurality of external connection terminals including a first external connection terminal, a second external connection terminal, and a third external connection terminal. The at least one integrated circuit includes at least one switch included in a switched-capacitor circuit configured to generate, based on an input voltage, a plurality of discrete voltages; at least one switch included in a first supply modulator configured to selectively output, based on a first envelope signal, at least one of the plurality of discrete voltages to the first external connection terminal; and at least one switch included in a second supply modulator configured to selectively output, based on a second envelope signal, at least one of the plurality of discrete voltages to the second external connection terminal. The third external connection terminal receives none of the plurality of discrete voltages from the first supply modulator and the second supply modulator. The third external connection terminal is disposed between the first external connection terminal and the second external connection terminal in plan view of the module substrate.

A tracker module according to an aspect of the present invention includes a module substrate; at least one integrated circuit disposed on or in the module substrate; and a plurality of external connection terminals including a first external connection terminal and a second external connection terminal. The at least one integrated circuit includes at least one switch included in a switched-capacitor circuit configured to generate, based on an input voltage, a plurality of discrete voltages; at least one switch included in a first supply modulator configured to selectively output, based on a first envelope signal, at least one of the plurality of discrete voltages to the first external connection terminal; and at least one switch included in a second supply modulator configured to selectively output, based on a second envelope signal, at least one of the plurality of discrete voltages to the second external connection terminal. The module substrate has a first side and a second side that constitute at least a part of an outer shape of the module substrate in plan view of the module substrate. The plurality of external connection terminals include a first set of external connection terminals disposed along the first side and a second set of external connection terminals disposed along the second side. The first external connection terminal is included in the first set of external connection terminals. The second external connection terminal is included in the second set of external connection terminals.

A tracker module according to an aspect of the present invention includes a module substrate; at least one integrated circuit disposed on or in the module substrate; and a plurality of external connection terminals including a first external connection terminal, a second external connection terminal, and a third external connection terminal. The at least one integrated circuit includes at least one switch included in a switched-capacitor circuit, at least one switch included in a first supply modulator, and at least one switch included in a second supply modulator. The switched-capacitor circuit includes a first capacitor having a first electrode and a second electrode, and a second capacitor having a third electrode and a fourth electrode. The at least one switch included in the switched-capacitor circuit includes a first switch, a second switch, a third switch, a fourth switch, a fifth switch, a sixth switch, a seventh switch, and an eighth switch. One terminal of the first switch and one terminal of the third switch are connected to the first electrode. One terminal of the second switch and one terminal of the fourth switch are connected to the second electrode. One terminal of the fifth switch and one terminal of the seventh switch are connected to the third electrode. One terminal of the sixth switch and one terminal of the eighth switch are connected to the fourth electrode. The other terminal of the first switch, the other terminal of the second switch, the other terminal of the fifth switch, and the other terminal of the sixth switch are connected to each other. The other terminal of the third switch is connected to the other terminal of the seventh switch. The other terminal of the fourth switch is connected to the other terminal of the eighth switch. The at least one switch included in the first supply modulator includes a ninth switch connected between the first external connection terminal and each of the other terminal of the first switch, the other terminal of the second switch, the other terminal of the fifth switch, and the other terminal of the sixth switch; and a tenth switch connected between the first external connection terminal and each of the other terminal of the third switch and the other terminal of the seventh switch. The at least one switch included in the second supply modulator includes an eleventh switch connected between the second external connection terminal and each of the other terminal of the first switch, the other terminal of the second switch, the other terminal of the fifth switch, and the other terminal of the sixth switch; and a twelfth switch connected between the second external connection terminal and each of the other terminal of the third switch and the other terminal of the seventh switch. The third external connection terminal is a ground terminal connected to ground, and is disposed between the first external connection terminal and the second external connection terminal in plan view of the module substrate.

### Advantageous Effects of Invention

A tracker module according to an aspect of the present invention is capable of supplying a plurality of power supply voltages to a plurality of PAs and reducing interference between the plurality of power supply voltages.

### Brief Description of Drawings

[Fig. 1] Fig. 1 is a circuit configuration diagram of a communication device according to a first embodiment.
[Fig. 2] Fig. 2 is a circuit configuration diagram of a pre-regulator circuit, a switched-capacitor circuit, supply modulators, and filter circuits according to the first embodiment.
[Fig. 3A] Fig. 3A is a graph illustrating a power supply voltage supplied by digital envelope tracking.
[Fig. 3B] Fig. 3B is a graph illustrating a power supply voltage supplied by analog envelope tracking.
[Fig. 4] Fig. 4 is a plan view of a tracker module according to an example of the first embodiment.
[Fig. 5] Fig. 5 is a plan view of the tracker module according to the example of the first embodiment.
[Fig. 6] Fig. 6 is a sectional view of the tracker module according to the example of the first embodiment.
[Fig. 7] Fig. 7 is a circuit configuration diagram of a supply modulator and a filter circuit additionally provided in a power supply circuit according to a second embodiment.
[Fig. 8] Fig. 8 is a plan view of a tracker module according to a first example of the second embodiment.
[Fig. 9] Fig. 9 is a plan view of the tracker module according to the first example of the second embodiment.
[Fig. 10] Fig. 10 is a plan view of a tracker module according to a second example of the second embodiment.
[Fig. 11] Fig. 11 is a plan view of a tracker module according to a third example of the second embodiment. Description of Embodiments

Hereinafter, embodiments of the present invention will be described in detail with reference to the drawings. The embodiments described below each illustrate a general or specific example. The numerical values, shapes, materials, constituent elements, the arrangement and connection manner of the constituent elements, and so forth described in the following embodiments are merely examples, and are not intended to limit the present invention.

The drawings are schematic diagrams drawn with emphasis, omission, or ratio adjustment performed as appropriate in order to illustrate the present invention. The illustration therein is not necessarily strict, and may be different from actual shapes, positional relationships, and ratios. In the drawings, constituent elements that are substantially the same are denoted by the same reference numerals, and a repeated description thereof may be omitted or simplified.

In the drawings referred to below, an x-axis and a y-axis are axes orthogonal to each other on a plane parallel to main surfaces of a module substrate. Specifically, in a case where the module substrate has a rectangular shape in plan view, the x-axis is parallel to a first side of the module substrate, and the y-axis is parallel to a second side orthogonal to the first side of the module substrate. A z-axis is an axis perpendicular to the main surfaces of the module substrate. The positive direction thereof indicates an upward direction, and the negative direction thereof indicates a downward direction.

Regarding the circuit configurations of the present invention, "connected" includes not only a direct connection using a connection terminal and/or a wiring conductor, but also an electrical connection via another circuit element. "Connected between A and B" means connected to both A and B between A and B, and includes a series connection to a path connecting A and B and a parallel connection (shunt connection) between the path and ground.

Regarding the disposition of components in the present invention, "a component is disposed on or in a substrate" includes that the component is disposed on a main surface of the substrate and that the component is disposed in the substrate. "A component is disposed on a main surface of a substrate" includes not only that the component is disposed in contact with the main surface of the substrate but also that the component is disposed above the main surface without being in contact with the main surface (for example, the component is stacked on another component disposed in contact with the main surface). "A component is disposed on a main surface of a substrate" may include that the component is disposed in a recessed portion formed on the main surface. "A component is disposed in a substrate" includes not only that the component is encapsulated in the module substrate but also that the entire component is disposed between both main surfaces of the substrate but a part of the component is not covered with the substrate and that only a part of the component is disposed in the substrate.

Regarding the disposition of components in the present invention, "in plan view of a module substrate" means that an object is viewed by orthographic projection on an xy plane from a z-axis positive side. "A overlaps B in plan view" means that a region of A orthographically projected on the xy plane overlaps a region of B orthographically projected on the xy plane.

Regarding the disposition of components in the present invention, "A is disposed adjacent to B" means that A and B are disposed close to each other, and specifically means that there is no other circuit component in a space where A faces B. In other words, "A is disposed adjacent to B" means that none of a plurality of line segments extending to B from certain points on a surface of A facing B in a normal direction of the surface passes through a circuit component other than A and B. Here, the circuit component means a component including an active element and/or a passive element. That is, the circuit component includes an active component including a transistor, a diode, or the like, and a passive component including an inductor, a transformer, a capacitor, a resistor, or the like, but does not include an electromechanical component including a terminal, a connector, a wiring line, or the like. "A is disposed between B and C" means that at least one of a plurality of line segments connecting certain points in B and certain points in C passes through A.

In addition, terms indicating the relationships between elements, such as "parallel" and "perpendicular", terms indicating the shapes of elements, such as "rectangular", and numerical ranges do not represent only strict meanings, but include substantially equivalent ranges, for example, an error of about several percent.

### (First embodiment)

Hereinafter, a tracker module and a communication device according to a first embodiment will be described with reference to the drawings.

### [1.1. Circuit configurations of communication device 7 and power supply circuit 1]

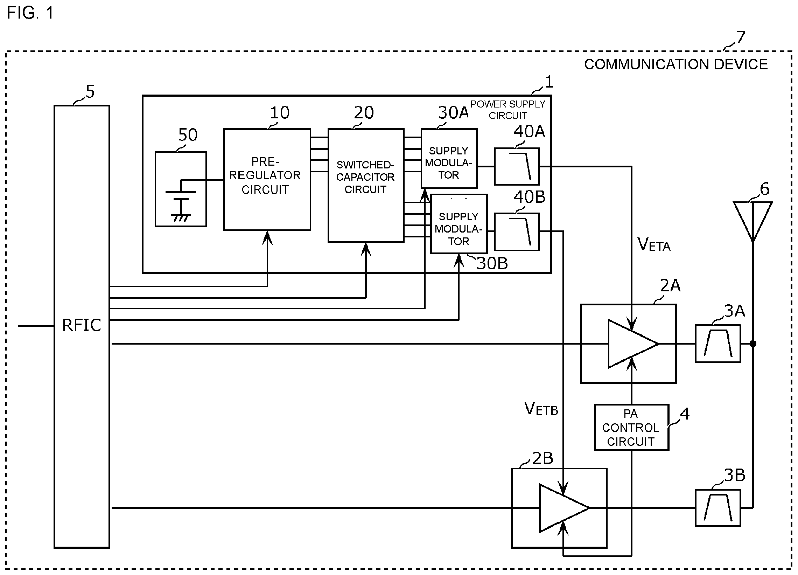

The circuit configuration of a communication device 7 according to the present embodiment will be described with reference to Fig. 1. Fig. 1 is a circuit configuration diagram of the communication device 7 according to the present embodiment.

### [1.1.1. Circuit configuration of communication device 7]

First, the circuit configuration of the communication device 7 will be described. As illustrated in Fig. 1, the communication device 7 according to the present embodiment includes a power supply circuit 1, power amplifiers (PAs) 2A and 2B, filters 3A and 3B, a PA control circuit 4, a radio frequency integrated circuit (RFIC) 5, and an antenna 6.

The power supply circuit 1 is capable of supplying power supply voltages V_{ETA} and V_{ETB} to the PAs 2A and 2B, respectively, in a digital envelope tracking (ET) mode. In the digital ET mode, the voltage level of each of the power supply voltages V_{ETA} and V_{ETB} is selected from among a plurality of discrete voltage levels based on a digital control signal corresponding to an envelope signal, and changes with time.

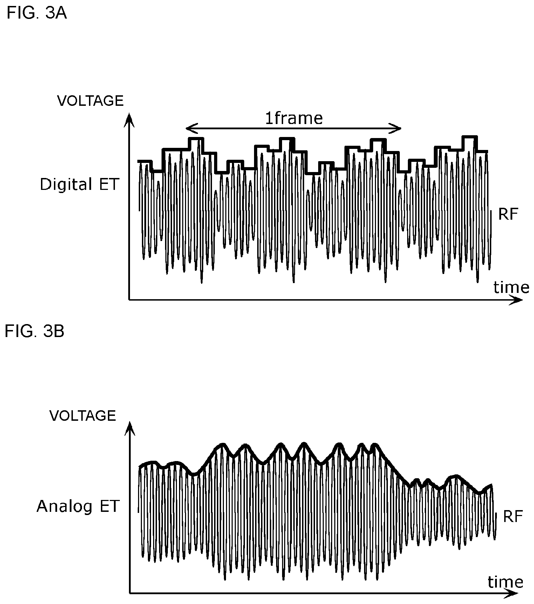

The envelope signal is a signal indicating the envelope value of a modulated signal (RF signal). The envelope value is represented by, for example, the square root of (I² + Q²). (I, Q) represents a constellation point herein. The constellation point is a point representing, on a constellation diagram, a signal modulated by digital modulation. The details of the digital ET mode will be described below with reference to Fig. 3A and Fig. 3B.

Although the power supply circuit 1 supplies the two power supply voltages V_{ETA} and V_{ETB} to the two PAs 2A and 2B, respectively in Fig. 1, the power supply circuit 1 may supply the same power supply voltage to the plurality of PAs.

As illustrated in Fig. 1, the power supply circuit 1 includes a pre-regulator circuit 10, a switched-capacitor circuit 20, supply modulators 30A and 30B, filter circuits 40A and 40B, and a direct current (DC) power source 50.

The pre-regulator circuit 10 includes a power inductor and a switch. The power inductor is an inductor used to raise and/or lower a DC voltage. The power inductor is disposed in series with a DC path. Alternatively, the power inductor may be connected between a series path and ground (disposed in parallel). The pre-regulator circuit 10 is capable of converting an input voltage into a first voltage by using the power inductor. Such a pre-regulator circuit 10 may also be referred to as a magnetic regulator or a DC-DC converter.

The pre-regulator circuit 10 does not necessarily have to include the power inductor, and may be, for example, a circuit or the like that raises a voltage by switching between capacitors respectively disposed in a series arm path and a parallel arm path of the pre-regulator circuit 10. The pre-regulator circuit 10 may further include a transformer.

The switched-capacitor circuit 20 includes a plurality of capacitors and a plurality of switches, and is capable of generating, from the first voltage received from the pre-regulator circuit 10, a plurality of second voltages as a plurality of discrete voltages each having a corresponding one of a plurality of discrete voltage levels. The switched-capacitor circuit 20 may also be referred to as a switched-capacitor voltage balancer.

The supply modulators 30A and 30B are examples of a first supply modulator and a second supply modulator, respectively, and are each capable of selecting at least one of the plurality of second voltages generated by the switched-capacitor circuit 20 and outputting the selected voltage to a corresponding one of the filter circuits 40A and 40B, based on a digital control signal corresponding to an envelope signal.

The filter circuits 40A and 40B are examples of a first filter circuit and a second filter circuit, respectively, and are each capable of filtering a signal (second voltage) from a corresponding one of the supply modulators 30A and 30B.

The DC power source 50 is capable of supplying a DC voltage to the pre-regulator circuit 10. The DC power source 50 may be, but is not limited to, a rechargeable battery, for example.

The power supply circuit 1 does not necessarily have to include at least one of the pre-regulator circuit 10, the switched-capacitor circuit 20, the supply modulators 30A and 30B, the filter circuits 40A and 40B, and the DC power source 50. For example, the power supply circuit 1 does not necessarily have to include the pre-regulator circuit 10, the filter circuits 40A and 40B, or the DC power source 50. Any combination of the pre-regulator circuit 10, the switched-capacitor circuit 20, the supply modulators 30A and 30B, and the filter circuits 40A and 40B may be integrated into a single circuit.

The PA 2A is connected between the RFIC 5 and the filter 3A. The PA 2A is capable of receiving the power supply voltage V_{ETA} from the power supply circuit 1 and receiving a bias signal from the PA control circuit 4. Accordingly, the PA 2A is capable of amplifying a transmission signal of band A received from the RFIC 5.

The PA 2B is connected between the RFIC 5 and the filter 3B. The PA 2B is capable of receiving the power supply voltage V_{ETB} from the power supply circuit 1 and receiving a bias signal from the PA control circuit 4. Accordingly, the PA 2B is capable of amplifying a transmission signal of band B received from the RFIC 5.

The filter 3A is connected between the PA 2A and the antenna 6. The filter 3A has a passband including band A. Accordingly, the filter 3A is capable of passing the transmission signal of band A amplified by the PA 2A.

The filter 3B is connected between the PA 2B and the antenna 6. The filter 3B has a passband including band B. Accordingly, the filter 3B is capable of passing the transmission signal of band B amplified by the PA 2B.

The PA control circuit 4 is capable of controlling the PAs 2A and 2B. Specifically, the PA control circuit 4 is capable of supplying a bias signal to each of the PAs 2A and 2B.

The RFIC 5 is an example of a signal processing circuit that processes an RF signal. Specifically, the RFIC 5 performs signal processing such as up-conversion on a transmission signal input thereto, and supplies an RF transmission signal generated through the signal processing to the PAs 2A and 2B. The RFIC 5 includes a control unit that controls the power supply circuit 1. Some or all of the functions of the control unit of the RFIC 5 may be implemented outside the RFIC 5.

The antenna 6 transmits the signal of band A input from the PA 2A through the filter 3A and the signal of band B input from the PA 2B through the filter 3B.

Bands A and B are frequency bands for a communication system constructed using the radio access technology (RAT). Bands A and B are defined in advance by standardizing bodies (for example, 3rd Generation Partnership Project (3GPP, registered trademark), Institute of Electrical and Electronics Engineers (IEEE), and so forth). Examples of the communication system include a 5th Generation New Radio (5G NR) system, a Long Term Evolution (LTE) system, and a Wireless Local Area Network (WLAN) system.

In the present embodiment, bands A and B is a combination of bands in which signals can be transmitted simultaneously. For example, bands A and B are used for inter-band carrier aggregation. In this case, the power supply circuit 1 simultaneously supplies the power supply voltages V_{ETA} and V_{ETB} to the PAs 2A and 2B.

The circuit configuration of the communication device 7 illustrated in Fig. 1 is illustrative, and is not restrictive. For example, the communication device 7 does not necessarily have to include the antenna 6. For example, the communication device 7 may include a plurality of antennas.

### [1.1.2. Circuit configuration of power supply circuit 1]

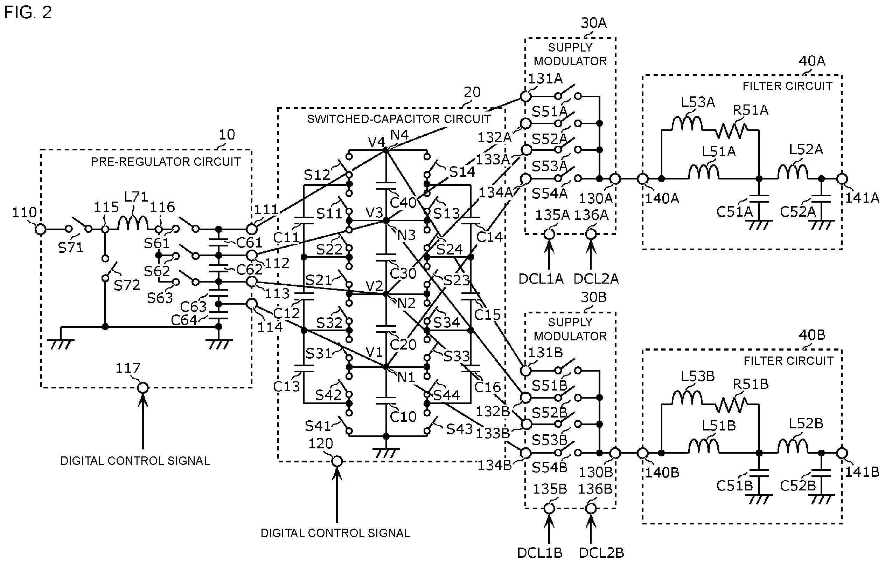

Next, the circuit configurations of the pre-regulator circuit 10, the switched-capacitor circuit 20, the supply modulators 30A and 30B, and the filter circuits 40A and 40B included in the power supply circuit 1 will be described with reference to Fig. 2. Fig. 2 is a circuit configuration diagram of the pre-regulator circuit 10, the switched-capacitor circuit 20, the supply modulators 30A and 30B, and the filter circuits 40A and 40B according to the present embodiment.

Fig. 2 illustrates exemplary circuit configurations. The pre-regulator circuit 10, the switched-capacitor circuit 20, the supply modulators 30A and 30B, and the filter circuits 40A and 40B may be mounted by using any one of a wide variety of circuit packaging methods and circuit techniques. Thus, the description of the individual circuits provided below should not be construed in a limiting manner.

### [1.1.2.1. Circuit configuration of switched-capacitor circuit 20]

First, the circuit configuration of the switched-capacitor circuit 20 will be described. As illustrated in Fig. 2, the switched-capacitor circuit 20 includes capacitors C11 to C16, capacitors C10, C20, C30, and C40, switches S11 to S14, S21 to S24, S31 to S34, and S41 to S44, and a control terminal 120. Energy and electric charge are input from the pre-regulator circuit 10 to the switched-capacitor circuit 20 at nodes N1 to N4 and output from the switched-capacitor circuit 20 to the supply modulators 30A and 30B at the nodes N1 to N4.

The control terminal 120 is an input terminal for a digital control signal. More specifically, the control terminal 120 is a terminal for receiving a digital control signal for controlling the switched-capacitor circuit 20. The digital control signal received via the control terminal 120 is, for example, a control signal of a source synchronous scheme in which a data signal and a clock signal are transmitted, but is not limited thereto. For example, the digital control signal may be a control signal of a clock embedded scheme in which a clock is embedded in a data signal.

The capacitors C11 to C16 each function as a flying capacitor (also referred to as a transfer capacitor). Specifically, the capacitors C11 to C16 are each used to raise or lower the first voltage supplied from the pre-regulator circuit 10. More specifically, the capacitors C11 to C16 cause electric charges to move between the capacitors C11 to C16 and the nodes N1 to N4 so that voltages V1 to V4 (voltages with respect to a ground potential) satisfying V1:V2:V3:V4 = 1:2:3:4 are maintained at the four nodes N1 to N4. The voltages V1 to V4 correspond to the plurality of second voltages each having a corresponding one of a plurality of discrete voltage levels.

The capacitor C11 has two electrodes. One of the two electrodes of the capacitor C11 is connected to one terminal of the switch S11 and one terminal of the switch S12. The other of the two electrodes of the capacitor C11 is connected to one terminal of the switch S21 and one terminal of the switch S22.

The capacitor C12 is an example of a first capacitor and has two electrodes (an example of a first electrode and a second electrode). One of the two electrodes of the capacitor C12 is connected to the one terminal of the switch S21 and the one terminal of the switch S22. The other of the two electrodes of the capacitor C12 is connected to one terminal of the switch S31 and one terminal of the switch S32.

The capacitor C13 has two electrodes. One of the two electrodes of the capacitor C13 is connected to the one terminal of the switch S31 and the one terminal of the switch S32. The other of the two electrodes of the capacitor C13 is connected to one terminal of the switch S41 and one terminal of the switch S42.

The capacitor C14 has two electrodes. One of the two electrodes of the capacitor C14 is connected to one terminal of the switch S13 and one terminal of the switch S14. The other of the two electrodes of the capacitor C14 is connected to one terminal of the switch S23 and one terminal of the switch S24.

The capacitor C15 is an example of a second capacitor and has two electrodes (an example of a third electrode and a fourth electrode). One of the two electrodes of the capacitor C15 is connected to the one terminal of the switch S23 and the one terminal of the switch S24. The other of the two electrodes of the capacitor C15 is connected to one terminal of the switch S33 and one terminal of the switch S34.

The capacitor C16 has two electrodes. One of the two electrodes of the capacitor C16 is connected to the one terminal of the switch S33 and the one terminal of the switch S34. The other of the two electrodes of the capacitor C16 is connected to one terminal of the switch S43 and one terminal of the switch S44.

A set of the capacitors C11 and C14, a set of the capacitors C12 and C15, and a set of the capacitors C13 and C16 can each be charged and discharged in a complementary manner as a result of a first phase and a second phase being repeated.

Specifically, in the first phase, the switches S12, S13, S22, S23, S32, S33, S42, and S43 are turned ON. Accordingly, for example, the one of the two electrodes of the capacitor C12 is connected to the node N3, the other of the two electrodes of the capacitor C12 and the one of the two electrodes of the capacitor C15 are connected to the node N2, and the other of the two electrodes of the capacitor C15 is connected to the node N1.

On the other hand, in the second phase, the switches S11, S14, S21, S24, S31, S34, S41, and S44 are turned ON. Accordingly, for example, the one of the two electrodes of the capacitor C15 is connected to the node N3, the other of the two electrodes of the capacitor C15 and the one of the two electrodes of the capacitor C12 are connected to the node N2, and the other of the two electrodes of the capacitor C12 is connected to the node N1.

As a result of the first phase and the second phase being repeated, for example, when one of the capacitors C12 and C15 is charged through the node N2, the other of the capacitors C12 and C15 can be discharged to the capacitor C30. In short, the capacitors C12 and C15 can be charged and discharged in a complementary manner.

Similarly to the set of the capacitors C12 and C15, the set of the capacitors C11 and C14 and the set of the capacitors C13 and C16 can each be charged and discharged in a complementary manner as a result of the first phase and the second phase being repeated.

The capacitors C10, C20, C30, and C40 each function as a smoothing capacitor. Specifically, the capacitors C10, C20, C30, and C40 are used to hold and smooth the voltages V1 to V4 at the nodes N1 to N4, respectively.

The capacitor C10 is connected between the node N1 and ground. Specifically, one of the two electrodes of the capacitor C10 is connected to the node N1. On the other hand, the other of the two electrodes of the capacitor C10 is connected to ground.

The capacitor C20 is connected between the nodes N2 and N1. Specifically, one of the two electrodes of the capacitor C20 is connected to the node N2. On the other hand, the other of the two electrodes of the capacitor C20 is connected to the node N1.

The capacitor C30 is connected between the nodes N3 and N2. Specifically, one of the two electrodes of the capacitor C30 is connected to the node N3. On the other hand, the other of the two electrodes of the capacitor C30 is connected to the node N2.

The capacitor C40 is connected between the nodes N4 and N3. Specifically, one of the two electrodes of the capacitor C40 is connected to the node N4. On the other hand, the other of the two electrodes of the capacitor C40 is connected to the node N3.

The switch S11 is connected between the one of the two electrodes of the capacitor C11 and the node N3. Specifically, the one terminal of the switch S11 is connected to the one of the two electrodes of the capacitor C11. On the other hand, the other terminal of the switch S11 is connected to the node N3.

The switch S12 is connected between the one of the two electrodes of the capacitor C11 and the node N4. Specifically, the one terminal of the switch S12 is connected to the one of the two electrodes of the capacitor C11. On the other hand, the other terminal of the switch S12 is connected to the node N4.

The switch S21 is an example of a first switch and is connected between the one of the two electrodes of the capacitor C12 and the node N2. Specifically, the one terminal of the switch S21 is connected to the one of the two electrodes of the capacitor C12 and the other of the two electrodes of the capacitor C11. On the other hand, the other terminal of the switch S21 is connected to the node N2.

The switch S22 is an example of a third switch and is connected between the one of the two electrodes of the capacitor C12 and the node N3. Specifically, the one terminal of the switch S22 is connected to the one of the two electrodes of the capacitor C12 and the other of the two electrodes of the capacitor C11. On the other hand, the other terminal of the switch S22 is connected to the node N3.

The switch S31 is an example of a fourth switch and is connected between the other of the two electrodes of the capacitor C12 and the node N1. Specifically, the one terminal of the switch S31 is connected to the other of the two electrodes of the capacitor C12 and the one of the two electrodes of the capacitor C13. On the other hand, the other terminal of the switch S31 is connected to the node N1.

The switch S32 is an example of a second switch and is connected between the other of the two electrodes of the capacitor C12 and the node N2. Specifically, the one terminal of the switch S32 is connected to the other of the two electrodes of the capacitor C12 and the one of the two electrodes of the capacitor C13. On the other hand, the other terminal of the switch S32 is connected to the node N2. That is, the other terminal of the switch S32 is connected to the other terminal of the switch S21.

The switch S41 is connected between the other of the two electrodes of the capacitor C13 and ground. Specifically, the one terminal of the switch S41 is connected to the other of the two electrodes of the capacitor C13. On the other hand, the other terminal of the switch S41 is connected to ground.

The switch S42 is connected between the other of the two electrodes of the capacitor C13 and the node N1. Specifically, the one terminal of the switch S42 is connected to the other of the two electrodes of the capacitor C13. On the other hand, the other terminal of the switch S42 is connected to the node N1. That is, the other terminal of the switch S42 is connected to the other terminal of the switch S31.

The switch S13 is connected between the one of the two electrodes of the capacitor C14 and the node N3. Specifically, the one terminal of the switch S13 is connected to the one of the two electrodes of the capacitor C14. On the other hand, the other terminal of the switch S13 is connected to the node N3. That is, the other terminal of the switch S13 is connected to the other terminal of the switch S11 and the other terminal of the switch S22.

The switch S14 is connected between the one of the two electrodes of the capacitor C14 and the node N4. Specifically, the one terminal of the switch S14 is connected to the one of the two electrodes of the capacitor C14. On the other hand, the other terminal of the switch S14 is connected to the node N4. That is, the other terminal of the switch S14 is connected to the other terminal of the switch S12.

The switch S23 is an example of a fifth switch and is connected between the one of the two electrodes of the capacitor C15 and the node N2. Specifically, the one terminal of the switch S23 is connected to the one of the two electrodes of the capacitor C15 and the other of the two electrodes of the capacitor C14. On the other hand, the other terminal of the switch S23 is connected to the node N2. That is, the other terminal of the switch S23 is connected to the other terminal of the switch S21 and the other terminal of the switch S32.

The switch S24 is an example of a seventh switch and is connected between the one of the two electrodes of the capacitor C15 and the node N3. Specifically, the one terminal of the switch S24 is connected to the one of the two electrodes of the capacitor C15 and the other of the two electrodes of the capacitor C14. On the other hand, the other terminal of the switch S24 is connected to the node N3. That is, the other terminal of the switch S24 is connected to the other terminal of the switch S11, the other terminal of the switch S22, and the other terminal of the switch S13.

The switch S33 is an example of an eighth switch and is connected between the other of the two electrodes of the capacitor C15 and the node N1. Specifically, the one terminal of the switch S33 is connected to the other of the two electrodes of the capacitor C15 and the one of the two electrodes of the capacitor C16. On the other hand, the other terminal of the switch S33 is connected to the node N1. That is, the other terminal of the switch S33 is connected to the other terminal of the switch S31 and the other terminal of the switch S42.

The switch S34 is an example of a sixth switch and is connected between the other of the two electrodes of the capacitor C15 and the node N2. Specifically, the one terminal of the switch S34 is connected to the other of the two electrodes of the capacitor C15 and the one of the two electrodes of the capacitor C16. On the other hand, the other terminal of the switch S34 is connected to the node N2. That is, the other terminal of the switch S34 is connected to the other terminal of the switch S21, the other terminal of the switch S32, and the other terminal of the switch S23.

The switch S43 is connected between the other of the two electrodes of the capacitor C16 and ground. Specifically, the one terminal of the switch S43 is connected to the other of the two electrodes of the capacitor C16. On the other hand, the other terminal of the switch S43 is connected to ground.

The switch S44 is connected between the other of the two electrodes of the capacitor C16 and the node N1. Specifically, the one terminal of the switch S44 is connected to the other of the two electrodes of the capacitor C16. On the other hand, the other terminal of the switch S44 is connected to the node N1. That is, the other terminal of the switch S44 is connected to the other terminal of the switch S31, the other terminal of the switch S42, and the other terminal of the switch S33.

A first set of switches including the switches S12, S13, S22, S23, S32, S33, S42, and S43, and a second set of switches including the switches S11, S14, S21, S24, S31, S34, S41, and S44 are turned ON and OFF in a complementary manner. Specifically, in the first phase, the switches in the first set are turned ON whereas the switches in the second set are turned OFF. Conversely, in the second phase, the switches in the first set are turned OFF whereas the switches in the second set are turned ON.

For example, in one of the first phase and the second phase, charging from the capacitors C11 to C13 to the capacitors C10 to C40 is performed, and in the other of the first phase and the second phase, charging from the capacitors C14 to C16 to the capacitors C10 to C40 is performed. In other words, because the capacitors C10 to C40 are constantly charged by the capacitors C11 to C13 or the capacitors C14 to C16, the nodes N1 to N4 are rapidly replenished with electric charges even if currents rapidly flow from the nodes N1 to N4 to the supply modulator 30. Thus, potential variations at the nodes N1 to N4 can be reduced.

As a result of operating in the above-described manner, the switched-capacitor circuit 20 is capable of maintaining substantially equal voltages across each of the capacitors C10, C20, C30, and C40. Specifically, the voltages V1 to V4 (voltages with respect to the ground potential) satisfying V1:V2:V3:V4 = 1:2:3:4 are maintained at the four nodes labeled V1 to V4. The levels of the voltages V1 to V4 correspond to the plurality of discrete voltage levels that can be supplied to the supply modulators 30A and 30B by the switched-capacitor circuit 20.

The voltage ratio V1:V2:V3:V4 is not limited to 1:2:3:4. For example, the voltage ratio V1:V2:V3:V4 may be 1:2:4:8.

The configuration of the switched-capacitor circuit 20 illustrated in Fig. 2 is illustrative, and is not restrictive. In Fig. 2, the switched-capacitor circuit 20 is configured to be capable of supplying voltages of four discrete voltage levels, but the configuration is not limited thereto. The switched-capacitor circuit 20 may be configured to be capable of supplying voltages of any number of two or more discrete voltage levels. For example, in the case of supplying voltages of two discrete voltage levels, it is sufficient that the switched-capacitor circuit 20 include at least the capacitors C12 and C15 and the switches S21 to S24 and S31 to S34.

### [1.1.2.2. Circuit configurations of supply modulators 30A and 30B]

Next, the circuit configurations of the supply modulators 30A and 30B will be described. As illustrated in Fig. 2, the supply modulator 30A includes input terminals 131A to 134A, switches S51A to S54A, an output terminal 130A, and control terminals 135A and 136A. The supply modulator 30B includes input terminals 131B to 134B, switches S51B to S54B, an output terminal 130B, and control terminals 135B and 136B. Hereinafter, the supply modulator 30A will be described. The supply modulator 30B is similar to the supply modulator 30A and thus the description thereof is omitted. The supply modulator 30B may be integrated with the supply modulator 30A.

The output terminal 130A is connected to the filter circuit 40A. The output terminal 130A is a terminal for supplying the filter circuit 40A with at least one voltage selected from among the voltages V1 to V4.

The input terminals 131A to 134A are connected to the nodes N4 to N1 of the switched-capacitor circuit 20, respectively. The input terminals 131A to 134A are terminals for receiving the voltages V4 to V1 from the switched-capacitor circuit 20, respectively.

The control terminals 135A and 136A are input terminals for digital control signals. That is, the control terminals 135A and 136A are terminals for receiving digital control signals indicating one of the voltages V1 to V4. The supply modulator 30A controls ON/OFF of the switches S51A to S54A so as to select the voltage level indicated by the digital control signals.

The digital control signals received via the control terminals 135A and 136A may be two digitally controlled level (DCL) signals. The two DCL signals are each a 1-bit signal. The voltages V1 to V4 are each represented by a combination of two 1-bit signals. For example, V1, V2, V3, and V4 are represented by "00", "01", "10", and "11", respectively. A gray code may be used to express a voltage level.

Although two DCL signals are used in the present embodiment, the present invention is not limited thereto. For example, any number of three or more DCL signals may be used depending on the number of voltage levels. The digital control signals are not limited to DCL signals and may be source-synchronous control signals.

The switch S51A is connected between the input terminal 131A and the output terminal 130A. Specifically, the switch S51A has a terminal connected to the input terminal 131A and a terminal connected to the output terminal 130A. In this connection configuration, ON/OFF switching of the switch S51A enables switching between connection and disconnection between the input terminal 131A and the output terminal 130A.

The switch S52A is an example of a tenth switch, and is connected between the input terminal 132A and the output terminal 130A. Specifically, the switch S52A has a terminal connected to the input terminal 132A and a terminal connected to the output terminal 130A. In this connection configuration, ON/OFF switching of the switch S52A enables switching between connection and disconnection between the input terminal 132A and the output terminal 130A.

The switch S53A is an example of a ninth switch, and is connected between the input terminal 133A and the output terminal 130A. Specifically, the switch S53A has a terminal connected to the input terminal 133A and a terminal connected to the output terminal 130A. In this connection configuration, ON/OFF switching of the switch S53A enables switching between connection and disconnection between the input terminal 133A and the output terminal 130A.

The switch S54A is connected between the input terminal 134A and the output terminal 130A. Specifically, the switch S54A has a terminal connected to the input terminal 134A and a terminal connected to the output terminal 130A. In this connection configuration, ON/OFF switching of the switch S54A enables switching between connection and disconnection between the input terminal 134A and the output terminal 130A.

These switches S51A to S54A are controlled so as to be exclusively turned ON. In other words, only any one of the switches S51A to S54A is turned ON, and the others are turned OFF. Accordingly, the supply modulator 30A is capable of outputting one voltage selected from among the voltages V1 to V4.

The configuration of the supply modulator 30A illustrated in Fig. 2 is illustrative, and is not restrictive. In particular, the switches S51A to S54A may have any configuration as long as at least one of the four input terminals 131A to 134A can be selected and connected to the output terminal 130A. For example, the supply modulator 30A may further include a switch connected between a set of the switches S51A to S53A and a set of the switch S54A and the output terminal 130A. For example, the supply modulator 30A may further include a switch connected between a set of the switches S51A and S52A and a set of the switches S53A and S54A and the output terminal 130A.

In a case where voltages of two discrete voltage levels are supplied from the switched-capacitor circuit 20, it is sufficient that the supply modulator 30A include at least the switches S52A and S53A.

In the supply modulator 30B, the switch S53B is an example of an eleventh switch, and the switch S52B is an example of a twelfth switch.

### [1.1.2.3. Circuit configuration of pre-regulator circuit 10]

The configuration of the pre-regulator circuit 10 will be described. As illustrated in Fig. 2, the pre-regulator circuit 10 includes an input terminal 110, output terminals 111 to 114, inductor connection terminals 115 and 116, a control terminal 117, switches S61 to S63, S71, and S72, a power inductor L71, and capacitors C61 to C64.

The input terminal 110 is an input terminal for a DC voltage. Specifically, the input terminal 110 is a terminal for receiving an input voltage from the DC power source 50.

The output terminal 111 is an output terminal for the voltage V4. Specifically, the output terminal 111 is a terminal for supplying the voltage V4 to the switched-capacitor circuit 20. The output terminal 111 is connected to the node N4 of the switched-capacitor circuit 20.

The output terminal 112 is an output terminal for the voltage V3. Specifically, the output terminal 112 is a terminal for supplying the voltage V3 to the switched-capacitor circuit 20. The output terminal 112 is connected to the node N3 of the switched-capacitor circuit 20.

The output terminal 113 is an output terminal for the voltage V2. Specifically, the output terminal 113 is a terminal for supplying the voltage V2 to the switched-capacitor circuit 20. The output terminal 113 is connected to the node N2 of the switched-capacitor circuit 20.

The output terminal 114 is an output terminal for the voltage V1. Specifically, the output terminal 114 is a terminal for supplying the voltage V1 to the switched-capacitor circuit 20. The output terminal 114 is connected to the node N1 of the switched-capacitor circuit 20.

The inductor connection terminal 115 is connected to one end of the power inductor L71. The inductor connection terminal 116 is connected to the other end of the power inductor L71.

The control terminal 117 is an input terminal for a digital control signal. Specifically, the control terminal 117 is a terminal for receiving a digital control signal for controlling the pre-regulator circuit 10. The digital control signal received via the control terminal 117 is, for example, a control signal of a source synchronous scheme in which a data signal and a clock signal are transmitted, but is not limited thereto. For example, the digital control signal may be a control signal of a clock embedded scheme in which a clock is embedded in a data signal. The control terminal 117 may be integrated with the control terminal 120.

The switch S71 is connected between the input terminal 110 and the one end of the power inductor L71. Specifically, the switch S71 has a terminal connected to the input terminal 110, and a terminal connected to the one end of the power inductor L71 via the inductor connection terminal 115. In this connection configuration, ON/OFF switching of the switch S71 enables switching between connection and disconnection between the input terminal 110 and the one end of the power inductor L71.

The switch S72 is connected between the one end of the power inductor L71 and ground. Specifically, the switch S72 has a terminal connected to the one end of the power inductor L71 via the inductor connection terminal 115, and a terminal connected to ground. In this connection configuration, ON/OFF switching of the switch S72 enables switching between connection and disconnection between the one end of the power inductor L71 and ground.

The switch S61 is connected between the other end of the power inductor L71 and the output terminal 111. Specifically, the switch S61 has a terminal connected to the other end of power inductor L71, and a terminal connected to the output terminal 111. In this connection configuration, ON/OFF switching of the switch S61 enables switching between connection and disconnection between the other end of the power inductor L71 and the output terminal 111.

The switch S62 is connected between the other end of the power inductor L71 and the output terminal 112. Specifically, the switch S62 has a terminal connected to the other end of power inductor L71, and a terminal connected to the output terminal 112. In this connection configuration, ON/OFF switching of the switch S62 enables switching between connection and disconnection between the other end of the power inductor L71 and the output terminal 112.

The switch S63 is connected between the other end of the power inductor L71 and the output terminal 113. Specifically, the switch S63 has a terminal connected to the other end of power inductor L71, and a terminal connected to the output terminal 113. In this connection configuration, ON/OFF switching of the switch S63 enables switching between connection and disconnection between the other end of the power inductor L71 and the output terminal 113.

One of the two electrodes of the capacitor C61 is connected to the switch S61 and the output terminal 111. The other of the two electrodes of the capacitor C61 is connected to the switch S62, the output terminal 112, and one of the two electrodes of the capacitor C62.

The one of the two electrodes of the capacitor C62 is connected to the switch S62, the output terminal 112, and the other of the two electrodes of the capacitor C61. The other of the two electrodes of the capacitor C62 is connected to a path connecting the switch S63, the output terminal 113, and one of the two electrodes of the capacitor C63.

The one of the two electrodes of the capacitor C63 is connected to the switch S63, the output terminal 113, and the other of the two electrodes of the capacitor C62. The other of the two electrodes of the capacitor C63 is connected to the output terminal 114 and one of the two electrodes of the capacitor C64.

The one of the two electrodes of the capacitor C64 is connected to the output terminal 114 and the other of the two electrodes of the capacitor C63. The other of the two electrodes of the capacitor C64 is connected to ground.

The switches S61 to S63 are controlled so as to be exclusively turned ON. In other words, only any one of the switches S61 to S63 is turned ON, and the others are turned OFF. Turning ON of any one of the switches S61 to S63 enables the pre-regulator circuit 10 to change the voltage to be supplied to the switched-capacitor circuit 20 at the voltage levels of the voltages V2 to V4.

The pre-regulator circuit 10 configured as described above is capable of supplying electric charge to the switched-capacitor circuit 20 via at least one of the output terminals 111 to 113.

In a case where an input voltage is converted into one first voltage, it is sufficient that the pre-regulator circuit 10 include at least the switches S71 and S72 and the power inductor L71.

### [1.1.2.4. Circuit configurations of filter circuits 40A and 40B]

Next, the circuit configurations of the filter circuits 40A and 40B will be described. The filter circuits 40A and 40B each include a low pass filter (LPF). Specifically, as illustrated in Fig. 2, the filter circuit 40A includes inductors L51A to L53A, capacitors C51A and C52A, a resistor R51A, an input terminal 140A, and an output terminal 141A. The filter circuit 40B includes an LPF, and includes inductors L51B to L53B, capacitors C51B and C52B, a resistor R51B, an input terminal 140B, and an output terminal 141B. The filter circuit 40A will be described below. The filter circuit 40B is similar to the filter circuit 40A and thus the description thereof is omitted.

The input terminal 140A is an input terminal for a voltage selected by the supply modulator 30A. Specifically, the input terminal 140A is a terminal for receiving a voltage selected from among the plurality of voltages V1 to V4.

The output terminal 141A is an output terminal for the power supply voltage V_{ETA}. In other words, the output terminal 141A is a terminal for supplying the power supply voltage V_{ETA} to the PA 2A.

The inductors L51A to L53A, the capacitors C51A and C52A, and the resistor R51A constitute a low pass filter. Accordingly, the filter circuit 40A is capable of reducing RF components included in the power supply voltage. For example, when a predetermined band is a frequency band for frequency division duplex (FDD), the filter circuit 40A is configured to reduce frequency components of a gap between an uplink operating band and a downlink operating band of the predetermined band.

The configuration of the filter circuit 40A illustrated in Fig. 2 is illustrative, and is not restrictive. For example, the filter circuit 40A does not necessarily have to include the inductor L53A or the resistor R51A. For example, the filter circuit 40A may include an inductor connected to one of the two electrodes of the capacitor C51A, and may include an inductor connected to one of the two electrodes of the capacitor C52A.

### [1.2. Description of digital ET mode]

The digital ET mode will be described with reference to Fig. 3A and Fig. 3B in comparison with a conventional ET mode (hereinafter referred to as an analog ET mode). Fig. 3A is a graph illustrating an example of transition of a power supply voltage in the digital ET mode. Fig. 3B is a graph illustrating an example of transition of a power supply voltage in the analog ET mode. In Fig. 3A and Fig. 3B, the horizontal axis represents time, and the vertical axis represents voltage. A thick solid line represents a power supply voltage, and a thin solid line (waveform) represents a modulated signal.

In the digital ET mode, as illustrated in Fig. 3A, the power supply voltage is varied to a plurality of discrete voltage levels within one frame to track the envelope of the modulated signal. As a result, the power supply voltage signal forms a rectangular wave. In the digital ET mode, a power supply voltage level is selected or set from among a plurality of discrete voltage levels, based on an envelope signal.

A frame means a unit constituting an RF signal (modulated signal). For example, in 5G NR and LTE, a frame includes 10 subframes, each subframe includes a plurality of slots, and each slot is composed of a plurality of symbols. The subframe has a length of 1 ms, and the frame has a length of 10 ms.

In the analog ET mode, as illustrated in Fig. 3B, the power supply voltage is continuously varied to track the envelope of the modulated signal. In the analog ET mode, the power supply voltage is determined based on an envelope signal. In the analog ET mode, when the envelope of the modulated signal changes at a high speed, it is difficult for the power supply voltage to track the envelope.

### [1.3. Disposition of components of tracker module 100]

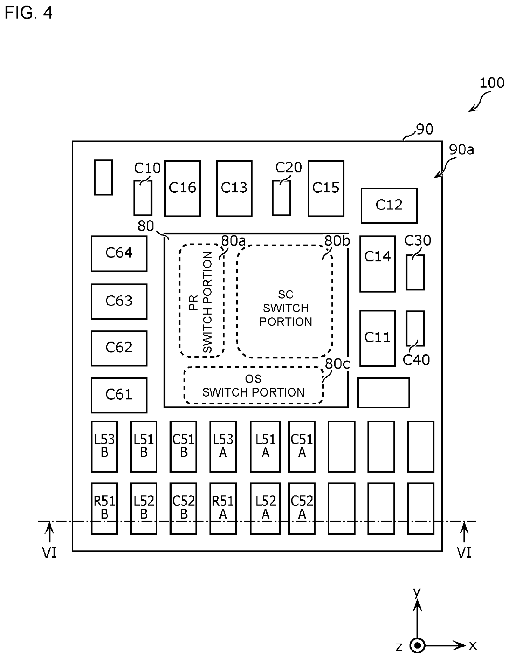

Next, a tracker module 100 equipped with the pre-regulator circuit 10 (except for the power inductor L71), the switched-capacitor circuit 20, the supply modulators 30A and 30B, and the filter circuits 40A and 40B will be described as an example of the power supply circuit 1 having the above-described configuration, with reference to Fig. 4 to Fig. 6. The power inductor L71 included in the pre-regulator circuit 10 does not necessarily have to be included in the tracker module 100, and is not illustrated in these figures.

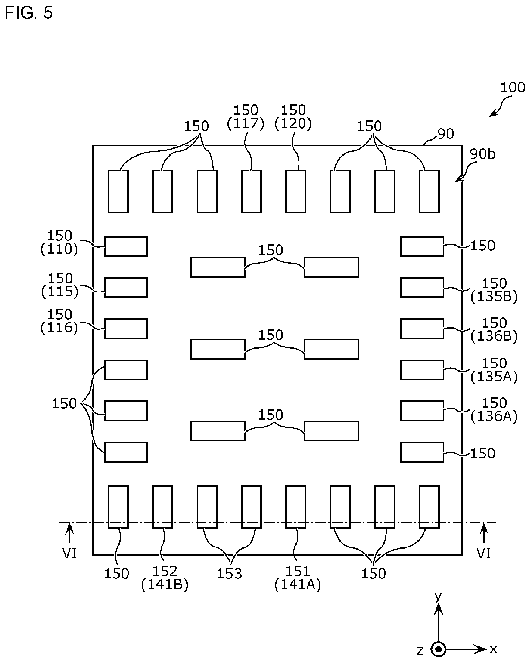

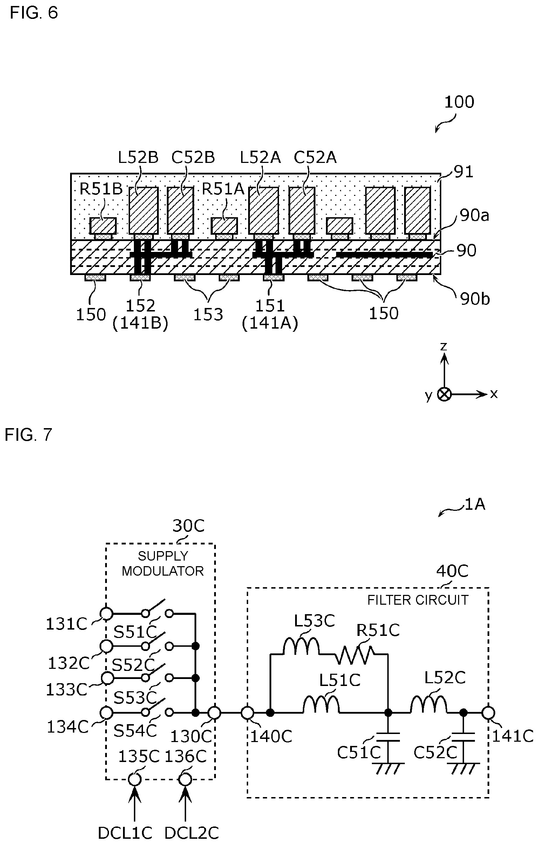

Fig. 4 is a plan view of the tracker module 100 according to the present example. Fig. 5 is a plan view of the tracker module 100 according to the present example, in which a main surface 90b side of a module substrate 90 is seen through from the positive side of the z-axis. Fig. 6 is a sectional view of the tracker module 100 according to the present example. The section of the tracker module 100 in Fig. 6 is a section taken along the VI-VI line in Fig. 4 and Fig. 5.

In Fig. 4 to Fig. 6, the illustration of some of wiring lines connecting a plurality of circuit components disposed on or in the module substrate 90 is omitted. In Fig. 4, the illustration of a resin member 91 covering the plurality of circuit components is omitted. In Fig. 4, the blocks not denoted by reference signs represent optional circuit components that are not essential to the present invention.

The tracker module 100 includes the module substrate 90, the resin member 91, and a plurality of land electrodes 150, in addition to the plurality of circuit components including active elements and passive elements (except for the power inductor L71) included in the pre-regulator circuit 10, the switched-capacitor circuit 20, the supply modulators 30A and 30B, and the filter circuits 40A and 40B illustrated in Fig. 2.

The module substrate 90 has a main surface 90a and the main surface 90b opposed to each other. The main surface 90a is an example of a first main surface, and the main surface 90b is an example of a second main surface. The module substrate 90 includes a wiring layer, via-conductors, a ground plane, and so forth formed therein. In Fig. 4 and Fig. 5, the module substrate 90 has a rectangular shape in plan view, but the shape is not limited thereto.

The module substrate 90 may be, but is not limited to, a low temperature co-fired ceramics (LTCC) substrate or a high temperature co-fired ceramics (HTCC) substrate having a multilayer structure of a plurality of dielectric layers, a component-embedded board, a substrate including a redistribution layer (RDL), a printed circuit board, or the like, for example.

On the main surface 90a, there are disposed an integrated circuit 80; the capacitors C10 to C16, C20, C30, C40, C51A, C51B, C52A, C52B, and C61 to C64; the inductors L51A to L53A and L51B to L53B; the resistors R51A and R51B; and the resin member 91.

The integrated circuit 80 includes a PR switch portion 80a, an SC switch portion 80b, and an OS switch portion 80c. The PR switch portion 80a includes the switches S61 to S63, S71, and S72. The SC switch portion 80b includes the switches S11 to S14, S21 to S24, S31 to S34, and S41 to S44. The OS switch portion 80c includes the switches S51A to S54A and S51B to S54B.

Although the PR switch portion 80a, the SC switch portion 80b, and the OS switch portion 80c are included in the single integrated circuit 80 in Fig. 4, the present invention is not limited thereto. For example, the PR switch portion 80a and the SC switch portion 80b may be included in an integrated circuit, and the OS switch portion 80c may be included in another integrated circuit. Alternatively, for example, the SC switch portion 80b and the OS switch portion 80c may be included in an integrated circuit, and the PR switch portion 80a may be included in another integrated circuit. Alternatively, the PR switch portion 80a and the OS switch portion 80c may be included in an integrated circuit, and the SC switch portion 80b may be included in another integrated circuit. Alternatively, for example, the PR switch portion 80a, the SC switch portion 80b, and the OS switch portion 80c may be included in three respective integrated circuits.

In Fig. 4, the integrated circuit 80 has a rectangular shape in plan view of the module substrate 90, but the shape is not limited thereto.

The integrated circuit 80 may be constituted by using, for example, complementary metal oxide semiconductor (CMOS), and specifically may be manufactured by a silicon on insulator (SOI) process. The integrated circuit 80 is not limited to CMOS.

The capacitors C10 to C16, C20, C30, C40, C51A, C52A, C51B, C52B, and C61 to C64 are each mounted as a chip capacitor. The chip capacitor means a surface mount device (SMD) constituting a capacitor. The implementation of the plurality of capacitors is not limited to chip capacitors. For example, some or all of the plurality of capacitors may be included in an integrated passive device (IPD) or may be included in the integrated circuit 80.

The inductors L51A to L53A and L51B to L53B are each mounted as a chip inductor. The chip inductor means an SMD constituting an inductor. The implementation of the plurality of inductors is not limited to chip inductors. For example, the plurality of inductors may be included in an IPD.

The resistors R51A and R51B are each mounted as a chip resistor. The chip resistor means an SMD constituting a resistor. The implementation of the resistors R51A and R51B is not limited to chip resistors. For example, the resistors R51A and R51B may be included in an IPD.

In this way, the plurality of capacitors, the plurality of inductors, and the plurality of resistors disposed on the main surface 90a are grouped for the individual circuits and disposed around the integrated circuit 80.

Specifically, a group of the capacitors C61 to C64 included in the pre-regulator circuit 10 is disposed in a region on the main surface 90a sandwiched between a straight line along the left side of the integrated circuit 80 and a straight line along the left side of the module substrate 90 in plan view of the module substrate 90. Accordingly, a group of the circuit components included in the pre-regulator circuit 10 is disposed near the PR switch portion 80a in the integrated circuit 80.

A group of the capacitors C10 to C16, C20, C30, and C40 included in the switched-capacitor circuit 20 is disposed in a region on the main surface 90a sandwiched between a straight line along the upper side of the integrated circuit 80 and a straight line along the upper side of the module substrate 90, and a region on the main surface 90a sandwiched between a straight line along the right side of the integrated circuit 80 and a straight line along the right side of the module substrate 90, in plan view of the module substrate 90. Accordingly, a group of the circuit components included in the switched-capacitor circuit 20 is disposed near the SC switch portion 80b in the integrated circuit 80.

A group of the capacitors C51A, C51B, C52A, and C52B, the inductors L51A to L53A and L51B to L53B, and the resistors R51A and R51B included in the filter circuits 40A and 40B is disposed in a region on the main surface 90a sandwiched between a straight line along the lower side of the integrated circuit 80 and a straight line along the lower side of the module substrate 90 in plan view of the module substrate 90. Accordingly, a group of the circuit components included in the switched-capacitor circuit 20 is disposed near the OS switch portion 80c in the integrated circuit 80. In other words, the OS switch portion 80c is disposed closer to the filter circuits 40A and 40B than the PR switch portion 80a and the SC switch portion 80b.

At least a part of the filter circuit 40A and at least a part of the filter circuit 40B are disposed adjacent to one side (lower side in Fig. 4) of the four sides of the integrated circuit 80. Specifically, at least one of the circuit components included in the filter circuit 40A (the capacitor C51A and the inductors L51A and L53A in Fig. 4) is disposed adjacent to the lower side of the integrated circuit 80. Furthermore, at least one of the circuit components included in the filter circuit 40B (the capacitor C51B in Fig. 4) is disposed adjacent to the lower side of the integrated circuit 80.

The plurality of land electrodes 150 are disposed on the main surface 90b. The plurality of land electrodes 150 function as a plurality of external connection terminals including a ground terminal in addition to the input terminal 110, the output terminals 141A and 141B, the inductor connection terminals 115 and 116, and the control terminals 117, 120, 135A, 135B, 136A, and 136B illustrated in Fig. 2. The plurality of land electrodes 150 are electrically connected to the plurality of electronic components disposed on the main surface 90a via the via-conductors or the like formed in the module substrate 90. The plurality of land electrodes 150 may be, but are not limited to, copper electrodes. For example, the plurality of land electrodes may be solder electrodes. Instead of the plurality of land electrodes 150, a plurality of bump electrodes or a plurality of post electrodes may be used as the plurality of external connection terminals.

The plurality of land electrodes 150 include land electrodes 151, 152, and 153. The land electrode 151 is an example of a first external connection terminal and functions as the output terminal 141A. The land electrode 151 overlaps at least a part of the filter circuit 40A in plan view of the module substrate 90. Specifically, the land electrode 151 overlaps the inductor L52A included in the filter circuit 40A in plan view of the module substrate 90 (see Fig. 6).

The land electrode 152 is an example of a second external connection terminal and functions as the output terminal 141B. The land electrode 152 overlaps at least a part of the filter circuit 40B in plan view of the module substrate 90. Specifically, the land electrode 152 overlaps the inductor L52B included in the filter circuit 40B in plan view of the module substrate 90 (see Fig. 6).

The land electrodes 153 are an example of a third external connection terminal and are disposed between the land electrodes 151 and 152 in plan view of the module substrate 90. The land electrodes 153 receive none of the plurality of second voltages from the supply modulators 30A and 30B. Here, the land electrodes 153 function as ground terminals. A ground terminal is a terminal connected to ground, and includes a terminal connected to ground via a switch or the like.

The land electrodes 153 are not limited to electrodes that function as ground terminals. That is, the land electrodes 153 may be electrodes that function as any terminals as long as none of the plurality of second voltages are output thereto from the supply modulators 30A and 30B, and may be electrodes that function as control terminals, for example. The number of land electrodes 153 is not limited to two. For example, the number of land electrodes 153 may be one, or may be any number of three or more.

The resin member 91 covers the main surface 90a and at least a part of the plurality of electronic components on the main surface 90a. The resin member 91 has a function of ensuring reliability, such as mechanical strength and moisture resistance, of the plurality of electronic components on the main surface 90a. The resin member 91 does not necessarily have to be included in the tracker module 100.

The configuration of the tracker module 100 according to the present example is illustrative, and is not restrictive. For example, one or some of the capacitors and inductors disposed on the main surface 90a may be formed in the module substrate 90. In addition, one or some of the capacitors and inductors disposed on the main surface 90a do not necessarily have to be included in the tracker module 100, and do not necessarily have to be disposed on or in the module substrate 90.

### [1.4. Advantageous effects and the like]

As described above, the tracker module 100 according to the present example includes the module substrate 90, the integrated circuit 80 disposed on or in the module substrate 90, and the plurality of land electrodes 150 including the land electrodes 151 to 153. The integrated circuit 80 includes at least one switch included in the switched-capacitor circuit 20 configured to generate, based on an input voltage, a plurality of discrete voltages; at least one switch included in the supply modulator 30A configured to selectively output, based on a first envelope signal, at least one of the plurality of discrete voltages to the land electrode 151; and at least one switch included in the supply modulator 30B configured to selectively output, based on a second envelope signal, at least one of the plurality of discrete voltages to the land electrode 152. The land electrode 153 receives none of the plurality of discrete voltages from the supply modulators 30A and 30B. The land electrode 153 is disposed between the land electrodes 151 and 152 in plan view of the module substrate 90.

Accordingly, the land electrode 153 is disposed between the land electrode 151 to which the voltage selected by the supply modulator 30A is output and the land electrode 152 to which the voltage selected by the supply modulator 30B is output. Thus, it is possible to dispose the land electrode 151 so as not to be adjacent to the land electrode 152, and reduce interference between two power supply voltages respectively supplied via the two land electrodes 151 and 152. In particular, the disposition of the land electrode 153 between the land electrodes 151 and 152 can effectively reduce the coupling between the land electrodes 151 and 152. In the analog ET mode, a circuit for generating a power supply voltage is necessary for each of power amplifiers that operate simultaneously. In the digital ET mode, a circuit for generating a power supply voltage (the switched-capacitor circuit 20 or the like) can be shared between a plurality of power amplifiers that operate simultaneously. Thus, in the tracker module 100 that supports the digital ET mode, in which the land electrodes 151 and 152 for supplying power supply voltages are likely to be disposed close to each other, the effect of reducing the coupling between the land electrodes 151 and 152 by the land electrode 153 is large.

For example, in the tracker module 100 according to the present example, the land electrode 153 may be a ground terminal connected to ground.

Accordingly, the coupling between the land electrodes 151 and 152 can be more effectively reduced.

For example, the tracker module 100 according to the present example may further include the filter circuit 40A disposed on or in the module substrate 90. The supply modulator 30A may be configured to output at least one discrete voltage selected from among the plurality of discrete voltages to the land electrode 151 via the filter circuit 40A. The module substrate 90 may have the main surface 90a and the main surface 90b opposed to each other. The filter circuit 40A may be disposed on the main surface 90a. The land electrode 151 may be disposed on the main surface 90b. At least a part of the filter circuit 40A may overlap at least a part of the land electrode 151 in plan view of the module substrate 90.

Accordingly, the wiring length between the filter circuit 40A and the land electrode 151 can be shortened, and wiring loss can be reduced.

For example, in the tracker module 100 according to the present example, the at least a part of the filter circuit 40A may be disposed adjacent to the integrated circuit 80.

Accordingly, the wiring length between the filter circuit 40A and the integrated circuit 80 can be shortened, and wiring loss can be further reduced.

For example, the tracker module 100 according to the present example may further include the filter circuit 40B disposed on or in the module substrate 90. The supply modulator 30B may be configured to output at least one discrete voltage selected from among the plurality of discrete voltages to the land electrode 152 via the filter circuit 40B. The filter circuit 40B may be disposed on the main surface 90a. The land electrode 152 may be disposed on the main surface 90b. At least a part of the filter circuit 40B may overlap at least a part of the land electrode 152 in plan view of the module substrate 90.

Accordingly, the wiring length between the filter circuit 40B and the land electrode 152 can be shortened, and wiring loss can be further reduced.

For example, in the tracker module 100 according to the present example, the at least a part of the filter circuit 40B may be disposed adjacent to the integrated circuit 80.

Accordingly, the wiring length between the filter circuit 40B and the integrated circuit 80 can be shortened, and wiring loss can be further reduced.

For example, in the tracker module 100 according to the present example, the integrated circuit 80 may be a single integrated circuit.

Accordingly, the switches included in the switched-capacitor circuit 20 and the supply modulator 30A can be integrated in the single integrated circuit 80, which can contribute to miniaturization of the tracker module 100.

From another viewpoint, the tracker module 100 according to the present example includes the module substrate 90, the integrated circuit 80 disposed on or in the module substrate 90, and the plurality of land electrodes 150 including the land electrodes 151 to 153. The integrated circuit 80 includes at least one switch included in the switched-capacitor circuit 20, at least one switch included in the supply modulator 30A, and at least one switch included in the supply modulator 30B. The switched-capacitor circuit 20 includes the capacitor C12 having two electrodes and the capacitor C15 having two electrodes. The at least one switch included in the switched-capacitor circuit 20 includes the switches S21 to S24 and S31 to S34. One terminal of the switch S21 and one terminal of the switch S22 are connected to one of the two electrodes of the capacitor C12. One terminal of the switch S32 and one terminal of the switch S31 are connected to the other of the two electrodes of the capacitor C12. One terminal of the switch S23 and one terminal of the switch S24 are connected to one of the two electrodes of the capacitor C15. One terminal of the switch S34 and one terminal of the switch S33 are connected to the other of the two electrodes of the capacitor C15. The other terminal of the switch S21, the other terminal of the switch S32, the other terminal of the switch S23, and the other terminal of the switch S34 are connected to each other. The other terminal of the switch S22 is connected to the other terminal of the switch S24. The other terminal of the switch S31 is connected to the other terminal of the switch S33. The at least one switch included in the supply modulator 30A includes the switch S53A connected between the land electrode 151 and each of the other terminal of the switch S21, the other terminal of the switch S32, the other terminal of the switch S23, and the other terminal of the switch S34; and the switch S52A connected between the land electrode 151 and each of the other terminal of the switch S22 and the other terminal of the switch S24. The at least one switch included in the supply modulator 30B includes the switch S53B connected between the land electrode 152 and each of the other terminal of the switch S21, the other terminal of the switch S32, the other terminal of the switch S23, and the other terminal of the switch S34; and the switch S52B connected between the land electrode 152 and each of the other terminal of the switch S22 and the other terminal of the switch S24. The land electrode 153 is a ground terminal connected to ground, and is disposed between the land electrodes 151 and 152 in plan view of the module substrate 90.

Accordingly, the land electrode 153 serving as a ground terminal is disposed between the land electrode 151 connected to the switched-capacitor circuit 20 via the supply modulator 30A and the land electrode 152 connected to the switched-capacitor circuit 20 via the supply modulator 30B. Thus, it is possible to dispose the land electrode 151 so as not to be adjacent to the land electrode 152, and reduce interference between two power supply voltages respectively supplied via the two land electrodes 151 and 152. In particular, the disposition of the land electrode 153 serving as a ground terminal between the land electrodes 151 and 152 can effectively reduce the coupling between the land electrodes 151 and 152. In the analog ET mode, a circuit for generating a power supply voltage is necessary for each of power amplifiers that operate simultaneously. In the digital ET mode, a circuit for generating a power supply voltage (the switched-capacitor circuit 20 or the like) can be shared between a plurality of power amplifiers that operate simultaneously. Thus, in the tracker module 100 that supports the digital ET mode, in which the land electrodes 151 and 152 for supplying power supply voltages are likely to be disposed close to each other, the effect of reducing the coupling between the land electrodes 151 and 152 by the land electrode 153 is large.

### (Second embodiment)

Next, a second embodiment will be described. The present embodiment is different from the first embodiment mainly in that a supply modulator and a filter circuit are additionally provided in the power supply circuit. Hereinafter, the present embodiment will be described with a focus on differences from the first embodiment with reference to the drawings.

### [2.1. Circuit configurations of additional circuits]

A supply modulator 30C and a filter circuit 40C additionally provided in a power supply circuit 1A according to the first embodiment will be described with reference to Fig. 7. Fig. 7 is a circuit configuration diagram of the supply modulator 30C and the filter circuit 40C additionally provided in the power supply circuit 1A according to the present embodiment.

### [2.1.1. Circuit configuration of supply modulator 30C]

The supply modulator 30C is an example of a third supply modulator, and includes input terminals 131C to 134C, switches S51C to S54C, an output terminal 130C, and control terminals 135C and 136C, as illustrated in Fig. 7. The description of the constituent elements of the supply modulator 30C is substantially the same as the description of the circuit configuration of the supply modulator 30A according to the first embodiment except that "A" in the reference signs is replaced with "C", and is thus omitted.

### [2.1.2. Circuit configuration of filter circuit 40C]

The filter circuit 40C is an example of a third filter circuit, and includes inductors L51C to L53C, capacitors C51C and C52C, a resistor R51C, an input terminal 140C, and an output terminal 141C, as illustrated in Fig. 7. The description of the constituent elements of the filter circuit 40C is substantially the same as the description of the circuit configuration of the filter circuit 40C according to the first embodiment except that "A" in the reference signs is replaced with "C", and is thus omitted.

### [2.2. Examples of power supply circuit 1A]

### [2.2.1. Disposition of components of tracker module 100A according to first example]

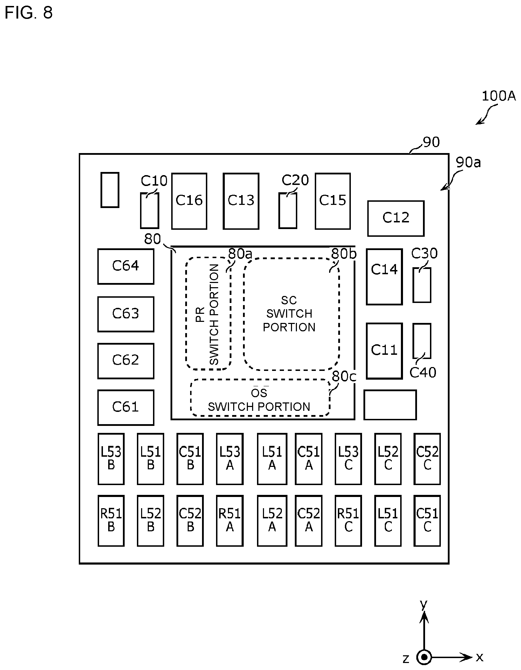

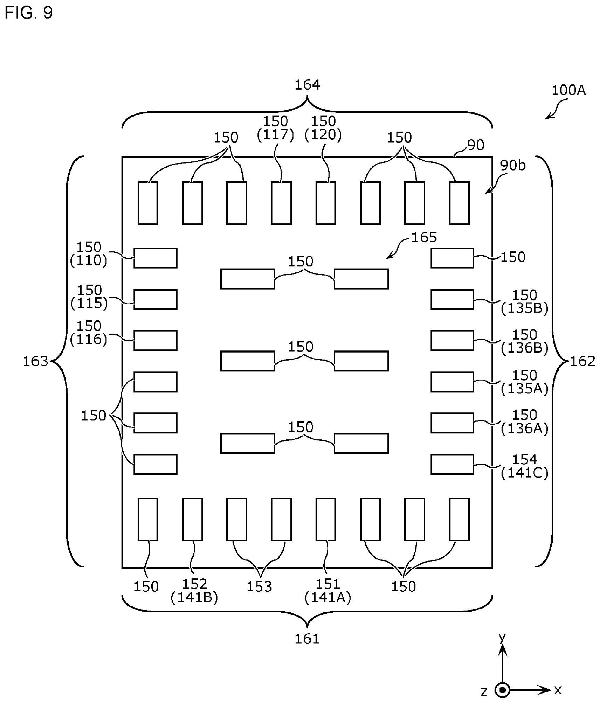

A tracker module 100A equipped with the supply modulator 30C and the filter circuit 40C in addition to the pre-regulator circuit 10 (except for the power inductor L71), the switched-capacitor circuit 20, the supply modulators 30A and 30B, and the filter circuits 40A and 40B will be described as a first example of the power supply circuit 1A according to the present embodiment, with reference to Fig. 8 and Fig. 9.

Fig. 8 is a plan view of the tracker module 100A according to the present example. Fig. 9 is a plan view of the tracker module 100A according to the present example, in which the main surface 90b side of the module substrate 90 is seen through from the positive side of the z-axis.

As illustrated in Fig. 8, on the main surface 90a, there are disposed the integrated circuit 80; the capacitors C10 to C16, C20, C30, C40, C51A, C51B, C51C, C52A, C52B, C52C, and C61 to C64; the inductors L51A to L53A, L51B to L53B, and L51C to L53C; the resistors R51A, R51B, and R51C; and the resin member 91.

The OS switch portion 80c included in the integrated circuit 80 includes the switches S51C to S54C in addition to the switches S51A to S54A and S51B to S54B.

The capacitors C51C and C52C, the inductors L51C to L53C, and the resistor R51C included in the filter circuit 40C are disposed in a region on the main surface 90a sandwiched between a straight line along the lower side of the integrated circuit 80 and a straight line along the lower side of the module substrate 90 in plan view of the module substrate 90. That is, at least a part of the filter circuit 40C is disposed adjacent to one side (lower side in Fig. 8) of the four sides of the integrated circuit 80. The one side is a side adjacent to the filter circuits 40A and 40B. Specifically, at least one of the circuit components included in the filter circuit 40C (the capacitor C51C and the inductors L51C and L53C in Fig. 8) is disposed adjacent to the lower side of the integrated circuit 80.

The plurality of land electrodes 150 are disposed on the main surface 90b. In the present example, the plurality of land electrodes 150 include a land electrode 154 in addition to the land electrodes 151 to 153. The land electrode 154 is an example of a fourth external connection terminal and functions as the output terminal 141C. The land electrode 154 overlaps at least a part of the filter circuit 40C in plan view of the module substrate 90. Specifically, the land electrode 154 overlaps the capacitor C52C and the inductor L52C included in the filter circuit 40C in the plan view of the module substrate 90.

The plurality of land electrodes 150 are grouped into five land electrode sets 161 to 165. The land electrode set 161 is an example of a first set of external connection terminals and is disposed along the lower side (an example of a first side) of the module substrate 90. The land electrodes 151, 152, and 153 are included in the land electrode set 161. The land electrode set 162 is an example of a second set of external connection terminals and is disposed along the right side (an example of a second side) of the module substrate 90. The land electrode 154 is included in the land electrode set 162. The land electrode set 163 is disposed along the left side of the module substrate 90. The land electrode set 164 is disposed along the upper side of the module substrate 90. The land electrode set 165 includes the other land electrodes 150 that are not included in any of the land electrode sets 161 to 164, and is disposed in a central portion on the main surface 90b of the module substrate 90 in Fig. 9.

As described above, in the tracker module 100A according to the present example, the plurality of land electrodes 150 may further include the land electrode 154. The integrated circuit 80 may further include at least one switch included in the supply modulator 30C configured to selectively output, based on a third envelope signal, at least one of the plurality of discrete voltages to the land electrode 154. The module substrate 90 may have a lower side and a right side that constitute at least a part of an outer shape of the module substrate 90 in plan view of the module substrate 90. The plurality of land electrodes 150 may include the land electrode set 161 disposed along the lower side and the land electrode set 162 disposed along the right side. The land electrodes 151 to 153 may be included in the land electrode set 161. The land electrode 154 may be included in the land electrode set 162.

Accordingly, the land electrode 154 to which the voltage selected by the supply modulator 30C is output is disposed along the right side different from the lower side along which the land electrodes 151 and 152 are disposed. Thus, it is possible to dispose the land electrode 153 so as not to be adjacent to the land electrode 151 or 152, and reduce interference between a power supply voltage supplied via the land electrode 153 and a power supply voltage supplied via the land electrode 151 or a power supply voltage supplied via the land electrode 152.

For example, the tracker module 100A according to the present example may further include the filter circuit 40C disposed on or in the module substrate 90. The supply modulator 30C may be configured to output at least one discrete voltage selected from among the plurality of discrete voltages to the land electrode 154 via the filter circuit 40C. The filter circuit 40C may be disposed on the main surface 90a. The land electrode 154 may be disposed on the main surface 90b. At least a part of the filter circuit 40C may overlap at least a part of the land electrode 154 in plan view of the module substrate 90.

Accordingly, the wiring length between the filter circuit 40C and the land electrode 154 can be shortened, and wiring loss can be further reduced.

For example, in the tracker module 100A according to the present example, the at least a part of the filter circuit 40C may be disposed adjacent to the integrated circuit 80.

Accordingly, the wiring length between the filter circuit 40C and the integrated circuit 80 can be shortened, and wiring loss can be further reduced.

### [2.2.2. Disposition of components of tracker module 100B according to second example]

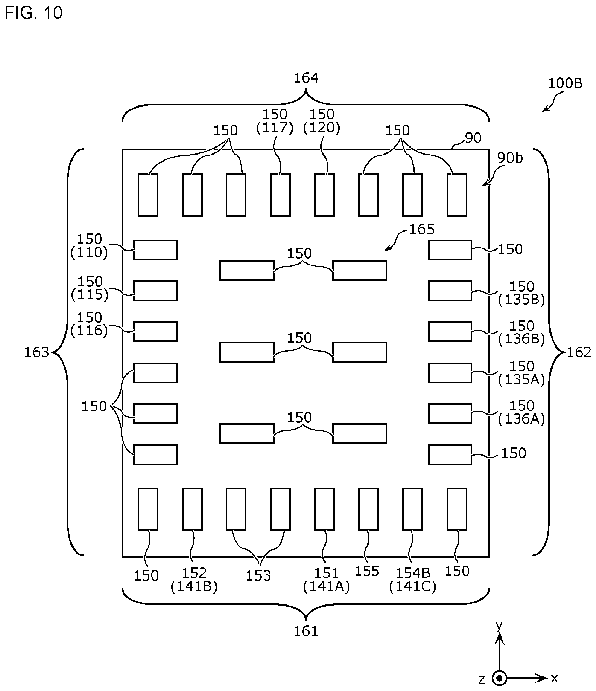

A tracker module 100B equipped with the supply modulator 30C and the filter circuit 40C in addition to the pre-regulator circuit 10 (except for the power inductor L71), the switched-capacitor circuit 20, the supply modulators 30A and 30B, and the filter circuits 40A and 40B will be described as a second example of the power supply circuit 1A according to the present embodiment, with reference to Fig. 10.

Fig. 10 is a plan view of the tracker module 100B according to the present example, in which the main surface 90b side of the module substrate 90 is seen through from the positive side of the z-axis.

In the present example, the plurality of land electrodes 150 include a land electrode 154B instead of the land electrode 154 and further include a land electrode 155.

The land electrode 154B is an example of a fourth external connection terminal and functions as the output terminal 141C. The land electrode 154B is included in the land electrode set 161.

The land electrode 155 is an example of a fifth external connection terminal and functions as a ground terminal. The land electrode 155 is disposed between the land electrodes 151 and 152 and the land electrode 154B in plan view of the module substrate 90.

The land electrode 155 is not limited to an electrode that functions as a ground terminal. For example, the land electrode 155 may be an electrode that functions as a control terminal. The number of land electrodes 155 is not limited to two. For example, the number of land electrodes 155 may be one, or may be any number of three or more.

As described above, in the tracker module 100B according to the present example, the plurality of land electrodes 150 may further include the land electrodes 154B and 155. The integrated circuit 80 may further include at least one switch included in the supply modulator 30C configured to selectively output, based on a third envelope signal, at least one of the plurality of discrete voltages to the land electrode 154B. The land electrode 155 may be disposed between the land electrode 154B and at least one of the land electrodes 151 and 152 in plan view of the module substrate.

Accordingly, the land electrode 153 is disposed between the land electrode 154B to which the voltage selected by the supply modulator 30C is output and at least one of the land electrodes 151 and 152 to which the voltages respectively selected by the supply modulators 30A and 30B are respectively output. Thus, it is possible to dispose the land electrode 154B so as not to be adjacent to the land electrode 151 and/or the land electrode 152, and reduce interference between a power supply voltage supplied via the land electrode 153 and a power supply voltage supplied via the land electrode 151 and/or the land electrode 152. In particular, the disposition of the land electrode 155 between the land electrode 154B and the land electrode 151 and/or the land electrode 152 can effectively reduce the coupling between the land electrode 154B and the land electrode 151 and/or the land electrode 152.

For example, in the tracker module 100B according to the present example, the land electrode 154B may be a ground terminal connected to ground.

Accordingly, the coupling between the land electrode 154B and the land electrode 151 and/or the land electrode 152 can be more effectively reduced.

### [2.2.3. Disposition of components of tracker module 100C according to third example]

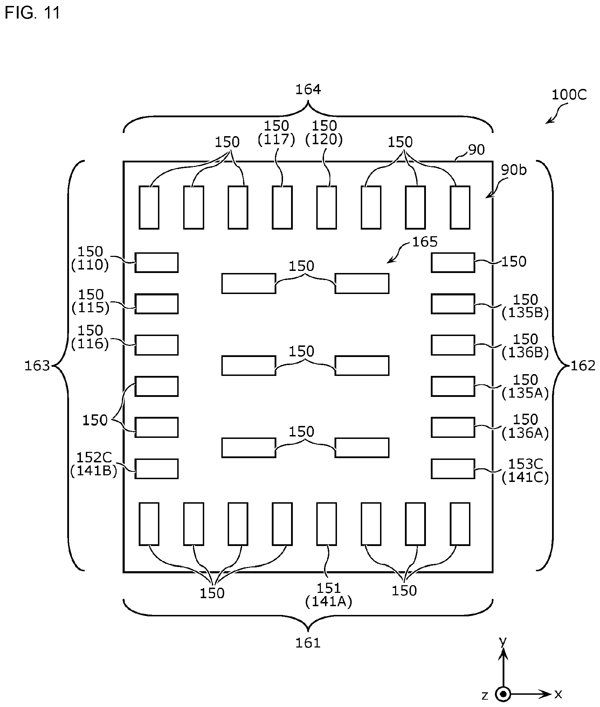

A tracker module 100C equipped with the supply modulator 30C and the filter circuit 40C in addition to the pre-regulator circuit 10 (except for the power inductor L71), the switched-capacitor circuit 20, the supply modulators 30A and 30B, and the filter circuits 40A and 40B will be described as a third example of the power supply circuit 1A according to the present embodiment, with reference to Fig. 11.

Fig. 11 is a plan view of the tracker module 100C according to the present example, in which the main surface 90b side of the module substrate 90 is seen through from the positive side of the z-axis.

In the present example, the plurality of land electrodes 150 include land electrodes 151, 152C, and 153C.

The land electrode 152C is an example of a second external connection terminal and functions as the output terminal 141B. The land electrode 152C is included in the land electrode set 163 (an example of a second set of external connection terminals). The land electrode set 163 is disposed along the left side (an example of a second side) of the module substrate 90.

The land electrode 153C is an example of a third external connection terminal and functions as the output terminal 141C. The land electrode 153C is included in the land electrode set 162 (an example of a third set of external connection terminals). The land electrode set 162 is disposed along the right side (an example of a third side) of the module substrate 90.

As described above, in the tracker module 100C according to the present example, the module substrate 90 may have a lower side and a left side that constitute at least a part of an outer shape of the module substrate 90 in plan view of the module substrate 90. The plurality of land electrodes 150 may include the land electrode set 161 disposed along the lower side of the module substrate 90 and the land electrode set 163 disposed along the left side of the module substrate 90. The land electrode 151 may be included in the land electrode set 161. The land electrode 152C may be included in the land electrode set 163.

Accordingly, the land electrode 151 to which the voltage selected by the supply modulator 30A is output and the land electrode 152C to which the voltage selected by the supply modulator 30B is output are disposed along sides different from each other. Thus, it is possible to dispose the land electrode 151 so as not to be adjacent to the land electrode 152C, and reduce interference between a power supply voltage supplied via the land electrode 151 and a power supply voltage supplied via the land electrode 152C.

For example, in the tracker module 100C according to the present example, the module substrate 90 may further have a right side that constitutes a part of the outer shape of the module substrate in plan view of the module substrate 90. The plurality of land electrodes 150 may further include the land electrode set 162 disposed along the right side. The land electrode 153C may be included in the land electrode set 162.

Accordingly, the land electrode 153C to which the voltage selected by the supply modulator 30C is output is disposed along the right side different from the lower side and the left side along which the land electrodes 151 and 152C are disposed, respectively. Thus, it is possible to dispose the land electrode 153C so as not to be adjacent to the land electrode 151 or 152C, and reduce interference between a power supply voltage supplied via the land electrode 153C and a power supply voltage supplied via the land electrode 151 or a power supply voltage supplied via the land electrode 152C.

### (Other embodiments)

The tracker module according to the present invention has been described above based on embodiments and examples. The tracker module according to the present invention is not limited to the above embodiments and examples. Another embodiment and another example implemented by combining any constituent elements in the above embodiments and the above examples, modifications obtained by applying various changes conceived by those skilled in the art to the above embodiments and above examples without departing from the gist of the present invention, and various devices including the above-described tracker module are also included in the present invention.

For example, in the circuit configurations of the various circuits according to the above embodiments, another circuit element, wiring line, and the like may be inserted between individual circuit elements and paths connecting signal paths disclosed in the drawings. For example, an impedance matching circuit may be inserted between the PA 2A and the filter 3A and/or between the filter 3A and the antenna 6.

### Industrial Applicability

The present invention can be widely used, as a tracker module for supplying a power supply voltage to a power amplifier, in communication devices such as mobile phones.

### Reference Signs List

1, 1A power supply circuit
2A, 2B power amplifier
3A, 3B filter
4 PA control circuit
5 RFIC
6 antenna
7 communication device
10 pre-regulator circuit
20 switched-capacitor circuit
30A, 30B, 30C supply modulator
40A, 40B, 40C filter circuit
50 DC power source
80 integrated circuit
80a PR switch portion
80b SC switch portion
80c OS switch portion
90 module substrate
90a, 90b main surface
91 resin member
100, 100A, 100B, 100C tracker module
110, 131A, 131B, 131C, 132A, 132B, 132C, 133A, 133B, 133C, 134A, 134B, 134C, 140A, 140B, 140C input terminal
111, 112, 113, 114, 130A, 130B, 130C, 141A, 141B, 141C output terminal
115, 116 inductor connection terminal
117, 120, 135A, 135B, 135C, 136A, 136B, 136C control terminal
150, 151, 152, 152C, 153, 153C, 154, 154B, 155 land electrode
C10, C11, C12, C13, C14, C15, C16, C20, C30, C40, C51A, C51B, C51C, C52A, C52B, C52C, C61, C62, C63, C64 capacitor
L51A, L51B, L51C, L52A, L52B, L52C, L53A, L53B, L53C inductor
L71 power inductor
N1, N2, N3, N4 node
R51A, R51B, R51C resistor
S11, S12, S13, S14, S21, S22, S23, S24, S31, S32, S33, S34, S41, S42, S43, S44, S51A, S51B, S51C, S52A, S52B, S52C, S53A, S53B, S53C, S54A, S54B, S54C, S61, S62, S63, S71, S72 switch
V1, V2, V3, V4 voltage

## Claims

1. A tracker module comprising:
a module substrate;
at least one integrated circuit disposed on or in the module substrate; and
a plurality of external connection terminals including a first external connection terminal, a second external connection terminal, and a third external connection terminal, wherein
the at least one integrated circuit includes:
at least one switch included in a switched-capacitor circuit configured to generate, based on an input voltage, a plurality of discrete voltages;
at least one switch included in a first supply modulator configured to selectively output, based on a first envelope signal, at least one of the plurality of discrete voltages to the first external connection terminal; and
at least one switch included in a second supply modulator configured to selectively output, based on a second envelope signal, at least one of the plurality of discrete voltages to the second external connection terminal,
the third external connection terminal receives none of the plurality of discrete voltages from the first supply modulator and the second supply modulator, and
the third external connection terminal is disposed between the first external connection terminal and the second external connection terminal in plan view of the module substrate.

2. The tracker module according to Claim 1, wherein
the third external connection terminal is a ground terminal connected to ground.

3. The tracker module according to Claim 1 or 2, wherein
the plurality of external connection terminals further include a fourth external connection terminal,
the at least one integrated circuit further includes at least one switch included in a third supply modulator configured to selectively output, based on a third envelope signal, at least one of the plurality of discrete voltages to the fourth external connection terminal,
the module substrate has a first side and a second side that constitute at least a part of an outer shape of the module substrate in plan view of the module substrate,
the plurality of external connection terminals include a first set of external connection terminals disposed along the first side and a second set of external connection terminals disposed along the second side,
the first external connection terminal, the second external connection terminal, and the third external connection terminal are included in the first set of external connection terminals, and
the fourth external connection terminal is included in the second set of external connection terminals.

4. The tracker module according to Claim 1 or 2, wherein
the plurality of external connection terminals further include a fourth external connection terminal and a fifth external connection terminal,
the at least one integrated circuit further includes at least one switch included in a third supply modulator configured to selectively output, based on a third envelope signal, at least one of the plurality of discrete voltages to the fourth external connection terminal, and
the fifth external connection terminal is disposed between the fourth external connection terminal and at least one of the first external connection terminal and the second external connection terminal in plan view of the module substrate.

5. The tracker module according to Claim 4, wherein
the fifth external connection terminal is a ground terminal connected to ground.

6. The tracker module according to any one of Claims 1 to 5, further comprising:
a first filter circuit disposed on or in the module substrate, wherein
the first supply modulator is configured to output at least one discrete voltage selected from among the plurality of discrete voltages to the first external connection terminal via the first filter circuit,
the module substrate has a first main surface and a second main surface opposed to each other,
the first filter circuit is disposed on the first main surface,
the first external connection terminal is disposed on the second main surface, and
at least a part of the first filter circuit overlaps at least a part of the first external connection terminal in plan view of the module substrate.

7. The tracker module according to Claim 6, wherein
the at least a part of the first filter circuit is disposed adjacent to the at least one integrated circuit.

8. The tracker module according to Claim 6 or 7, further comprising:
a second filter circuit disposed on or in the module substrate, wherein
the second supply modulator is configured to output at least one discrete voltage selected from among the plurality of discrete voltages to the second external connection terminal via the second filter circuit,
the second filter circuit is disposed on the first main surface,
the second external connection terminal is disposed on the second main surface, and
at least a part of the second filter circuit overlaps at least a part of the second external connection terminal in plan view of the module substrate.

9. The tracker module according to Claim 8, wherein
the at least a part of the second filter circuit is disposed adjacent to the at least one integrated circuit.

10. The tracker module according to any one of Claims 3 to 5, further comprising:
a third filter circuit disposed on or in the module substrate, wherein
the third supply modulator is configured to output at least one discrete voltage selected from among the plurality of discrete voltages to the fourth external connection terminal via the third filter circuit,
the module substrate has a first main surface and a second main surface opposed to each other,
the third filter circuit is disposed on the first main surface,
the fourth external connection terminal is disposed on the second main surface, and
at least a part of the third filter circuit overlaps at least a part of the fourth external connection terminal in plan view of the module substrate.

11. The tracker module according to Claim 10, wherein
the at least a part of the third filter circuit is disposed adjacent to the at least one integrated circuit.

12. The tracker module according to any one of Claims 1 to 11, wherein
the at least one integrated circuit is a single integrated circuit.

13. A tracker module comprising:
a module substrate;
at least one integrated circuit disposed on or in the module substrate; and
a plurality of external connection terminals including a first external connection terminal and a second external connection terminal, wherein
the at least one integrated circuit includes:
at least one switch included in a switched-capacitor circuit configured to generate, based on an input voltage, a plurality of discrete voltages;
at least one switch included in a first supply modulator configured to selectively output, based on a first envelope signal, at least one of the plurality of discrete voltages to the first external connection terminal; and
at least one switch included in a second supply modulator configured to selectively output, based on a second envelope signal, at least one of the plurality of discrete voltages to the second external connection terminal,
the module substrate has a first side and a second side that constitute at least a part of an outer shape of the module substrate in plan view of the module substrate,
the plurality of external connection terminals include a first set of external connection terminals disposed along the first side and a second set of external connection terminals disposed along the second side,
the first external connection terminal is included in the first set of external connection terminals, and
the second external connection terminal is included in the second set of external connection terminals.

14. The tracker module according to Claim 13, wherein
the plurality of external connection terminals further include a third external connection terminal,
the at least one integrated circuit further includes at least one switch included in a third supply modulator configured to selectively output, based on a third envelope signal, at least one of the plurality of discrete voltages to the third external connection terminal,
the module substrate further has a third side that constitutes a part of the outer shape of the module substrate in plan view of the module substrate,
the plurality of external connection terminals further include a third set of external connection terminals disposed along the third side, and
the third external connection terminal is included in the third set of external connection terminals.

15. A tracker module comprising:
a module substrate;
at least one integrated circuit disposed on or in the module substrate; and
a plurality of external connection terminals including a first external connection terminal, a second external connection terminal, and a third external connection terminal, wherein
the at least one integrated circuit includes:
at least one switch included in a switched-capacitor circuit;
at least one switch included in a first supply modulator; and
at least one switch included in a second supply modulator,
the switched-capacitor circuit includes a first capacitor having a first electrode and a second electrode, and a second capacitor having a third electrode and a fourth electrode,
the at least one switch included in the switched-capacitor circuit includes a first switch, a second switch, a third switch, a fourth switch, a fifth switch, a sixth switch, a seventh switch, and an eighth switch,
one terminal of the first switch and one terminal of the third switch are connected to the first electrode,
one terminal of the second switch and one terminal of the fourth switch are connected to the second electrode,
one terminal of the fifth switch and one terminal of the seventh switch are connected to the third electrode,
one terminal of the sixth switch and one terminal of the eighth switch are connected to the fourth electrode,
an other terminal of the first switch, an other terminal of the second switch, an other terminal of the fifth switch, and an other terminal of the sixth switch are connected to each other,
an other terminal of the third switch is connected to an other terminal of the seventh switch,
an other terminal of the fourth switch is connected to an other terminal of the eighth switch,
the at least one switch included in the first supply modulator includes:
a ninth switch connected between the first external connection terminal and each of the other terminal of the first switch, the other terminal of the second switch, the other terminal of the fifth switch, and the other terminal of the sixth switch; and
a tenth switch connected between the first external connection terminal and each of the other terminal of the third switch and the other terminal of the seventh switch,
the at least one switch included in the second supply modulator includes:
an eleventh switch connected between the second external connection terminal and each of the other terminal of the first switch, the other terminal of the second switch, the other terminal of the fifth switch, and the other terminal of the sixth switch; and
a twelfth switch connected between the second external connection terminal and each of the other terminal of the third switch and the other terminal of the seventh switch, and
the third external connection terminal is a ground terminal connected to ground, and is disposed between the first external connection terminal and the second external connection terminal in plan view of the module substrate.
